# DEMANDE DE BREVET EUROPEEN

(11) **EP 0 933 640 A2**
(43) Date de publication de la demande: **04.08.1999**
(21) Numéro de dépôt: 98123125.1
(22) Date de dépôt: 04.12.1998
(51) Int. Cl.: G01R 15/20

(54) **Dispositif d'alimentation en courant muni d'un capteur de courant**

(30) Priorité: 28.01.1998 CH 20798
(71) Demandeur: LIAISONS ELECTRONIQUES-MECANIQUES LEM S.A., CH-1228 Plan-les-Ouates (CH)
(72) Inventeur: Strübin, Pierre, 1293 Bellevue (CH)
(74) Mandataire: Hranitzky, Wilhelm Max

(57) **Abrégé**

Le présent dispositif comporte un conducteur (6') couplé avec un circuit magnétique à entrefer et connecté de façon à être parcouru par le courant à fournir par le dispositif. L'entrefer (14) contient un détecteur de champ magnétique (15) relié à un circuit de mesure ou de commande agencé de façon à produire un signal de sortie représentant le courant fourni par le dispositif d'alimentation.

## Description

La présente invention concerne un dispositif d'alimentation en courant électrique pour fournir un courant continu, ondulé ou impulsionnel à une charge, ce dispositif comportant au moins une bobine de self-induction couplée avec un circuit magnétique à entrefer, ou au moins un conducteur linéaire couplé avec un tel circuit, cette bobine ou ce conducteur étant connectés de façon à être parcourus par le courant à fournir.

Dans un dispositif d'alimentation de ce type, une self-inductance est généralement prévue afin d'assurer un lissage du courant fourni ou de permettre l'absorption de phénomènes transitoires. Dans le cas auquel s'applique l'invention, les moyens de self-inductance comprennent un circuit magnétique présentant au moins un entrefer dont la fonction première est d'éviter une saturation du matériau constituant le circuit magnétique.

On connaît par ailleurs des capteurs de courant utilisant la détection du champ magnétique engendré dans l'entrefer d'un circuit magnétique par un courant passant dans un conducteur couplé avec ce circuit magnétique, pour produire un signal représentant une image de ce courant. Il s'agit d'unités comportant leur propre circuit magnétique agencé de façon à pouvoir être couplé avec un conducteur primaire dont le courant est à mesurer.

L'adjonction d'une unité de capteur de courant à un dispositif d'alimentation en courant existant conduit à des coûts et à un encombrement souvent non acceptables dans la pratique.

L'invention a pour but de fournir un dispositif d'alimentation tel que mentionné au début dans lequel un capteur de courant est intégré de façon à occuper un minimum d'espace et à pouvoir être réalisé de manière très économique.

A cet effet, le dispositif selon l'invention est caractérisé par les particularités indiquées dans la revendication 1. Les revendications 2 et 3 décrivent des formes de réalisation préférées de ce dispositif.

D'autres caractéristiques, buts et avantages de l'invention ressortiront de la description d'un exemple de réalisation donnée ci-après et illustrée dans les dessins annexées, dans lesquels
la Fig. 1 montre le schéma de principe d'un dispositif d'alimentation à découpage connu et
la Fig. 2 montre schématiquement la disposition d'un détecteur de champ magnétique dans le circuit magnétique faisant partie de ce dispositif.

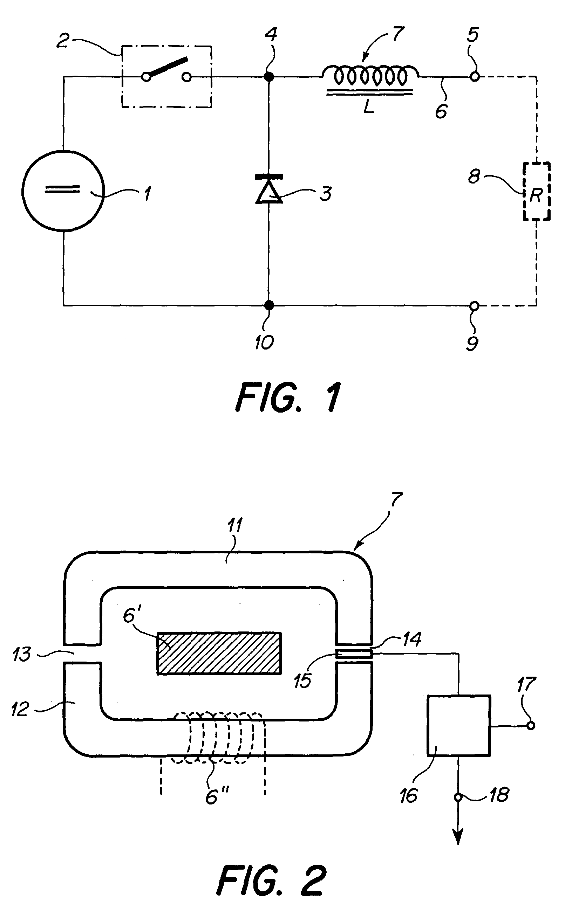

Le schéma de la Fig.1 comporte une source de tension continue 1 reliée à un interrupteur électronique 2, formé par exemple d'un transistor MOS, dont le chemin de conduction est monté en série avec une diode de roue libre 3. Le point de connexion commun 4 de l'interrupteur 2 et de la diode 3 est relié à une borne de sortie 5 du dispositif par un conducteur 6 et un élément de self - induction 7 est formé ou inséré dans cette branche du circuit. Une charge 8 est connectée entre la borne 5 et une seconde borne de sortie 9 du dispositif d'alimentation, cette borne étant reliée au point de connexion commun 10 de la diode 3 et de la source 1.

Lorsque l'interrupteur 2 est fermé, le courant dans la charge 8 augmente avec une pente définie par la constante de temps électrique du circuit, à savoir L/R, où L est l'inductance de l'élément 7 et R la résistance de la charge 8. Lorsque l'interrupteur 2 est ouvert, le courant décroît selon la même constante de temps à travers la diode 3. Ce modèle est valable en première approximation, si l'on néglige les résistances et inductances parasites du circuit et des semiconducteurs.

La self-inductance de l'élément 7 assure un lissage du courant fourni par le dispositif d'alimentation. Cette fonction se retrouve dans la plupart des convertisseurs de courant, comprenant par exemple des circuits pont, demi-pont, push-pull, etc.

La Fig. 2 représente schématiquement deux formes de réalisation de l'élément de self-induction 7. Selon une première exécution, le conducteur 6 présente une portion de conducteur linéaire 6' perpendiculaire au plan du dessin. Cette portion de conducteur 6' est entourée par un circuit magnétique constitué par deux parties 11, 12 en forme de U en un matériau magnétiquement perméable, par exemple en ferrite, les extrémités mutuellement opposées des parties 11 et 12 formant deux entrefers 13, 14. Dans une autre forme de réalisation, le conducteur 6 comporte un enroulement 6" formé, par exemple, de deux ou plusieurs spires enroulées autour d'une branche, telle que 12, du circuit magnétique.

Selon la présente invention, on mesure le champ magnétique par exemple dans l'entrefer 14, en disposant dans cet entrefer un détecteur 15, tel qu'un élément de Hall, une résistance sensible au champ magnétique du type GMR (Giga Magneto Resistance), un élément Flux Gate, ou un autre élément détecteur de champ magnétique approprié. Un circuit de mesure usuel, non représenté, est connecté au détecteur 15 et fournit un signal de sortie qui est une image du courant passant dans le conducteur 6, le champ magnétique détecté dans l'entrefer 14 étant proportionnel à ce courant en l'absence de saturation du circuit magnétique. Le signal de sortie obtenu peut être traité de manière appropriée et être utilisé notamment pour la commande du dispositif d'alimentation de façon à protéger la charge.

Le détecteur 15 peut être fixé dans l'entrefer par des moyens usuels et être relié à un circuit imprimé sur un support existant ou sur un support séparé muni de pins ou autres broches de connexion pour l'alimentation du circuit de mesure et la transmission du signal à un dispositif d'utilisation.

L'intégration d'un capteur de courant dans l'élément de self-induction existant dans le dispositif d'alimentation permet d'éviter l'utilisation d'un circuit magnétique séparé et constitue ainsi la clé d'une solution au problème crucial du coût et de l'encombrement de ces dispositifs d'alimentation.

## Revendications

1. Dispositif d'alimentation en courant électrique pour fournir un courant continu, ondulé ou impulsionnel à une charge, ce dispositif comportant au moins une bobine de self-induction couplée avec un circuit magnétique à entrefer, ou au moins un conducteur linéaire couplé avec un tel circuit, cette bobine ou ce conducteur étant connectés de façon à être parcourus par le courant à fournir, caractérisé en ce que ledit entrefer contient un détecteur de champ magnétique, ce détecteur étant relié à un circuit de mesure ou de commande agencé de façon à produire un signal de sortie représentant le courant fourni par le dispositif d'alimentation.

2. Dispositif selon la revendication 1, caractérisé en ce que ledit détecteur de champ magnétique est un élément de Hall, une résistance magnétosensible, ou un composant Flux Gate.

3. Dispositif selon la revendication 1, caractérisé en ce que ledit circuit de mesure ou de commande est réalisé au moins partiellement sous forme d'un circuit imprimé sur un support muni de moyens de connection à d'autres parties de circuit du dispositif d'alimentation de façon à assurer l'alimentation du circuit de mesure ou de commande et/ou la transmission dudit signal de sortie à des circuits de traitement de signal et/ou de commande du dispositif d'alimentation.
